Europäisches Patentamt

European Patent Office

Office européen des brevets

(19)

(11) Numéro de publication: **0 099 797**
A1

## (12) DEMANDE DE BREVET EUROPEEN

(21) Numéro de dépôt: 83401367.4

(22) Date de dépôt: 04.07.83

(51) Int. Cl.³: **H 03 K 13/18**
G 01 D 5/249

(30) Priorité: 05.07.82 FR 8211781

(43) Date de publication de la demande:
01.02.84 Bulletin 84/5

(84) Etats contractants désignés:
BE CH DE GB IT LI NL SE

(71) Demandeur: SOCIETE FRANCAISE D'EQUIPEMENTS
POUR LA NAVIGATION AERIENNE (S.F.E.N.A.)
B.P. 59 Aérodrome de Villacoublay
F-78140 Velizy Villacoublay(FR)

(72) Inventeur: Gruaz, Daniel
53, rue du Petit Pont
Montigny Le Bretonneux F-78190 Trappes(FR)

(72) Inventeur: Cabarbaye, André
16 rue Edmond Roger
F-75015 Paris(FR)

(74) Mandataire: Brot, Philippe et al,
CABINET BROT et JOLLY 83, rue d'Amsterdam
F-75008 Paris(FR)

(54) Capteur rotatif de position angulaire à sorties numériques.

(57) Le capteur fait intervenir un disque rotatif muni de plusieurs pistes de lecture circulaires concentriques comportant chacune deux séries alternées de secteurs de deux types différents. Ces pistes sont lues par des détecteurs (1, 2, A, B, C, D) appropriés. L'une des pistes est associée à $Z_1$ détecteurs (A, B, C, D) permettant de définir $Z_1$ bits de décodage relatif, l'autre ou les autres pistes font intervenir $Z_2$ détecteurs (1, 2) permettant de déterminer les bits de poids fort de la position angulaire du disque ainsi que le poids relatif des bits issus des $Z_1$ détecteurs.

L'invention permet de réaliser des capteurs de petites dimensions à haute résolution.

Fig. 4

EP 0 099 797 A1

Capteur rotatif de position angulaire à sorties numériques.

La présente invention concerne un capteur rotatif
de position angulaire à sorties numériques utilisant
un dispositif de codage à poids variable.

D'une manière générale on sait que les capteurs
rotatifs de position font généralement intervenir
un disque rotatif muni de plusieurs pistes de lecture
circulaires concentriques, comportant chacune une
série alternée de secteurs de deux types différents.

Au droit de chacune de ces pistes est associé un
détecteur approprié (senseur), susceptible de changer
d'état lorsqu'il passe d'un secteur de l'une des séries
à un secteur de l'autre série, ces détecteurs pouvant par exemple consister, selon la nature des secteurs, en des balais, des microcontacts, des couples
optoélectroniques, etc...

Dans l'état actuel de la technique, on utilise
généralement des capteurs rotatifs de type à codage
absolu, qui, pour une résolution angulaire de $\frac{2\pi}{2^n}$
nécessitent l'utilisation de $\underline{n}$ détecteurs disposés
respectivement sur $\underline{n}$ pistes concentriques.

Ainsi, par exemple, dans le cas d'un codeur de
résolution de $\frac{2\pi}{8}$ (c'est-à-dire $\frac{2\pi}{2^3}$), le disque comprendra nécessairement trois pistes associées respectivement à trois détecteurs, à savoir, une première
piste comprenant quatre secteurs du premier type
alternant avec quatre secteurs du deuxième type, une
deuxième piste comprenant deux secteurs du premier
type alternant avec deux secteurs du deuxième type, et
une troisième piste comprenant un secteur du premier
type alternant avec un secteur du second type.

Il est clair que l'utilisation de codeurs absolus
ne convient que dans le cas de capteurs de dimensions
relativement importantes et de résolution élevée.

Par contre, il s'avère que, dans le cas d'un codeur de faibles dimensions et de très haute résolution, le diamètre de la $n^{ième}$ piste serait si faible que le réalisation du disque ainsi que le positionnement des secteurs, nécessiteraient des précisions incompatibles avec des moyens classiques de fabrication.

A titre d'exemple, dans un capteur à codage absolu, de résolution $\frac{2\pi}{2^{12}}$ du type de celui précédemment décrit, utilisant un disque de diamètre D = 24 mm et présentant des pistes d'épaisseur e = 0,6 mm, le diamètre de la 12ème piste, d = D - 2ne serait de 9,6 mm et la largeur d'un incrément sur cette piste serait $1 = \frac{d}{2} \times \frac{2\pi}{2^{12}} =$ 0,007 mm. Il est clair que la réalisation d'un tel codeur poserait des problèmes techniques considérables.

L'invention a donc pour but de supprimer ces inconvénients. En vue de permettre la réalisation, par des techniques classiques de fabrication, des détecteurs de faibles dimensions avec cependant une haute résolution, elle propose une première solution permettant de diviser par deux le nombre des pistes qui seraient nécessaires dans le cas d'une réalisation classique.

Cette première solution consiste à diviser chaque piste en $2 \times 4^{k'}$ secteurs et à lire cette piste par deux détecteurs disposés de manière à former entre eux un angle de $(1 + 2k) \dfrac{\pi}{2 \times 4^{k'}}$ radians.

(k' et k étant des nombres entiers. k' étant le numéro de la piste).

Toutefois, cette solution ne permet pas, elle non plus, la réalisation de capteurs de très petites dimensions et à très haute résolution.

C'est la raison pour laquelle l'invention propose une seconde solution basée sur le principe de codage à poids variable et qui fait intervenir sur le disque :

- au moins une première piste divisée en $z_1$ zones dans lesquelles les secteurs sont de largeur variable d'une zone à l'autre. Au droit de cette piste sont disposés uniformément $z_1$ détecteurs permettant de définir $z_1$ bits de décodage relatif de la position angulaire $\Theta$ du disque, et

- au moins une piste supplémentaire permettant de réaliser un système de codage absolu du type de ceux précédemment décrits, ce système de codage faisant intervenir $z_2$ détecteurs permettant de définir la position du disque par rapport aux $z_1$ détecteurs associés à la première piste et de déterminer les $z_2$ bits de poids fort de la position angulaire $\Theta$ recherchée ainsi que le poids relatif des bits issus des $z_1$ détecteurs associés à la première piste.

Bien entendu, selon cette solution, pour une résolution de $\frac{2\pi}{2^n}$ le nombre total des détecteurs utilisés soit $z_1 + z_2$ doit être au moins égal à $\underline{n}$.

Par ailleurs, la résolution du système de codage absolu qui détermine le poids des bits délivrés par les détecteurs $z_1$ associés à la première piste doit être au moins égal à $\frac{2\pi}{z_1}$.

Selon une autre caractéristique de l'invention le disque du capteur peut comprendre, en partant du centre, une ou plusieurs pistes de codage absolu, et une ou plusieurs pistes de codage à poids variable.

Dans ce cas, la ou les pistes de codage absolu permettent de définir au moins le premier bit de poids fort de la position angulaire du disque ainsi que le poids relatif des bits générés par la première piste de codage à poids variable suivante.

Dans le cas où le disque comprend une deuxième piste de codage à poids variable, le poids relatif des bits générés par cette piste sera alors déterminé par un décodage des bits générés par la ou les pistes de codage absolu et par la première piste de codage à poids variable.

Il est clair que ce processus peut être étendu à un capteur dans lequel le disque comprend p pistes de codage à poids variable. Dans ce cas, le poids des bits générés par la $p^{ième}$ piste de codage à poids variable est déterminé par décodage des bits générés par les $p^{-1ième}$ pistes de codage à poids variable et par la ou les pistes de codage absolu.

Il convient de noter que le codage des pistes peut être effectué en binaire naturel ou en tout autre code. Toutefois il convient de noter que si on utilise un code de type "Gray", pour lever toute ambiguïté de lecture, les bits générés par la zone comprenant les plus petits secteurs, ne changeant que tous les deux incréments, la largeur de ces secteurs est deux fois plus importante dans le code Gray que dans le code binaire naturel.

Des modes de réalisation de l'invention seront décrits ci-après, à titre d'exemples non limitatifs, avec référence aux dessins annexés dans lesquels :

La figure 1 représente le disque d'un capteur rotatif de type classique, à résolution $\frac{2\pi}{8}$ et à codage absolu.

La figure 2 représente le disque d'un capteur rotatif de résolution $\frac{2\pi}{16}$, à codage absolu, comprenant deux pistes lues, chacune par deux détecteurs.

La figure 3 est un tableau de correspondance des positions angulaires $\Theta$ en fonction de l'état des détecteurs utilisés dans le capteur représenté figure 2.

La figure 4 représente le disque d'un capteur rotatif de résolution $\frac{2\pi}{64}$ utilisant le principe du codage à poids variable, avec codage en binaire absolu de la position angulaire $\Theta$ recherchée.

La figure 5 est la matrice de transcodage du capteur représenté figure 4.

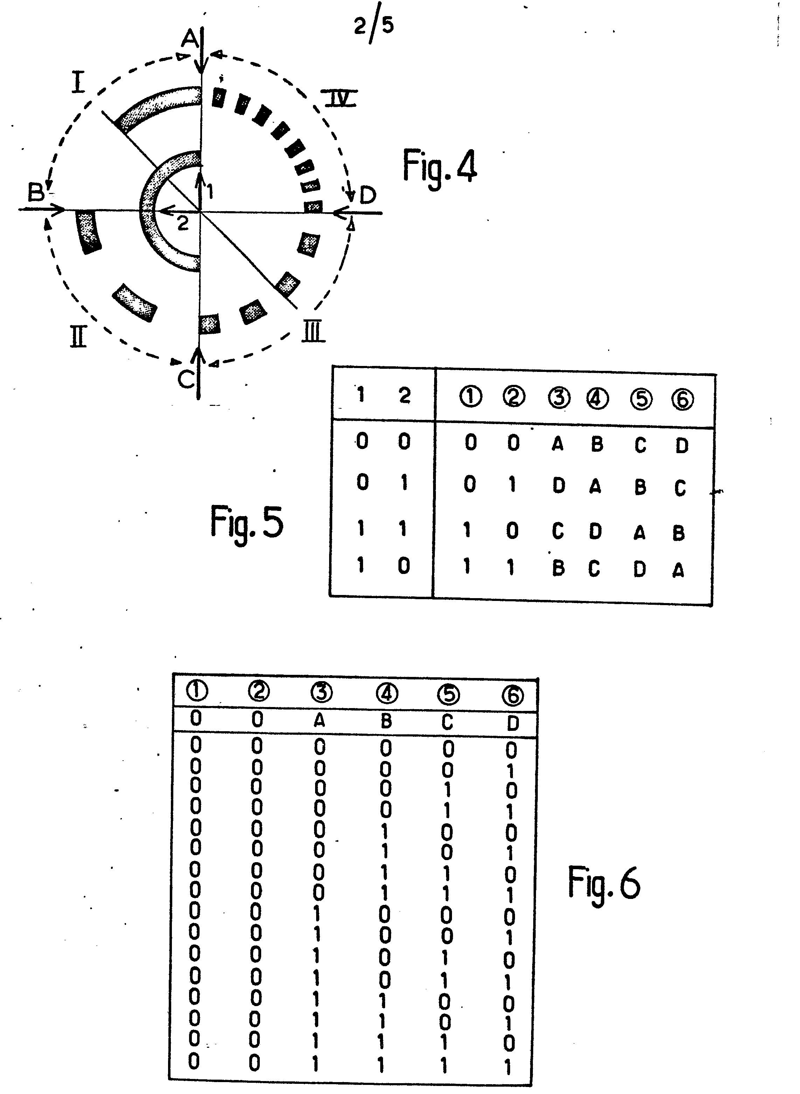

La figure 6 est un tableau représentant le codage en binaire absolu des positions angulaires $\Theta$ en fonction

des détecteurs utilisés dans le mode de réalisation représenté figure 4, dans le cas où les détecteurs 1 et 2 sont à l'état 0 (première ligne de la matrice de transcodage).

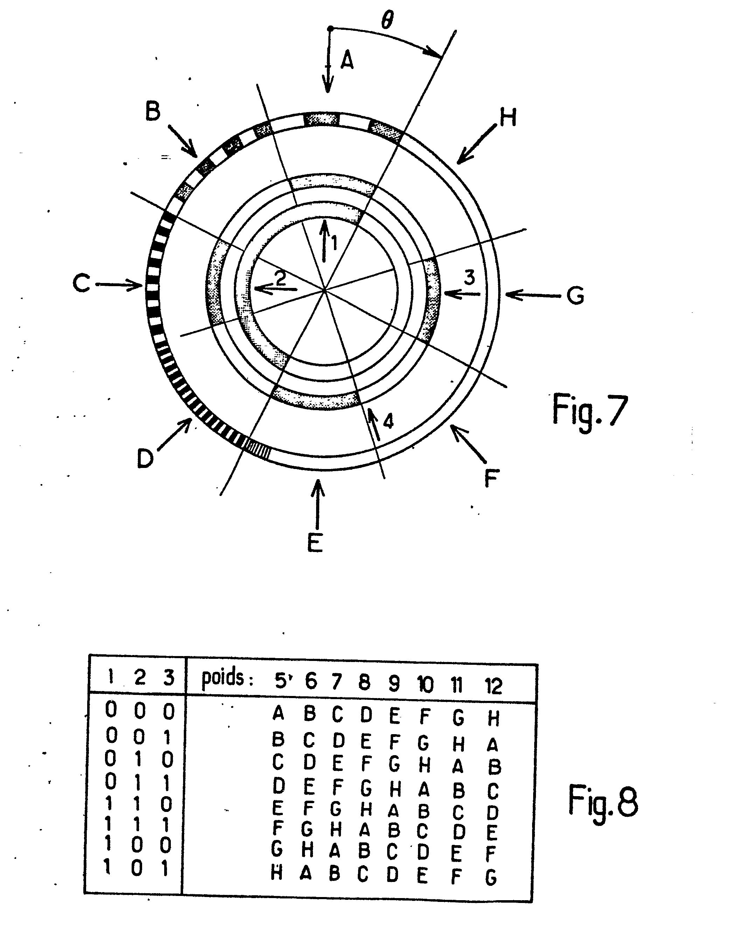

La figure 7 représente le disque d'un capteur rotatif de résolution $\frac{2\pi}{2^{12}}$ utilisant un codage à poids variable.

La figure 8 est un tableau représentant le poids des détecteurs en fonction de la configuration des trois premiers bits de codage absolu.

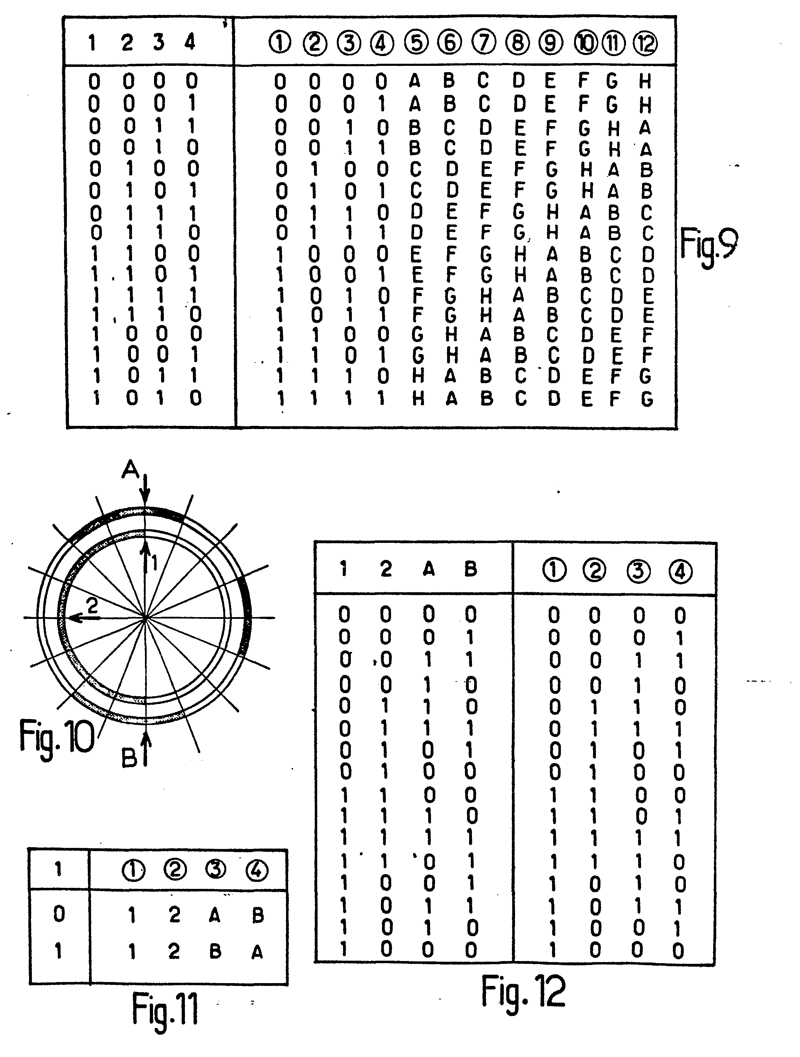

La figure 9 représente la matrice de transcodage du capteur représenté figure 7.

La figure 10 représente le disque d'un capteur de résolution $\frac{2\pi}{16}$ utilisant le principe du codage à poids variable dans lequel est introduit un codage binaire réfléchi.

La figure 11 est la matrice de transcodage du capteur représenté figure 10.

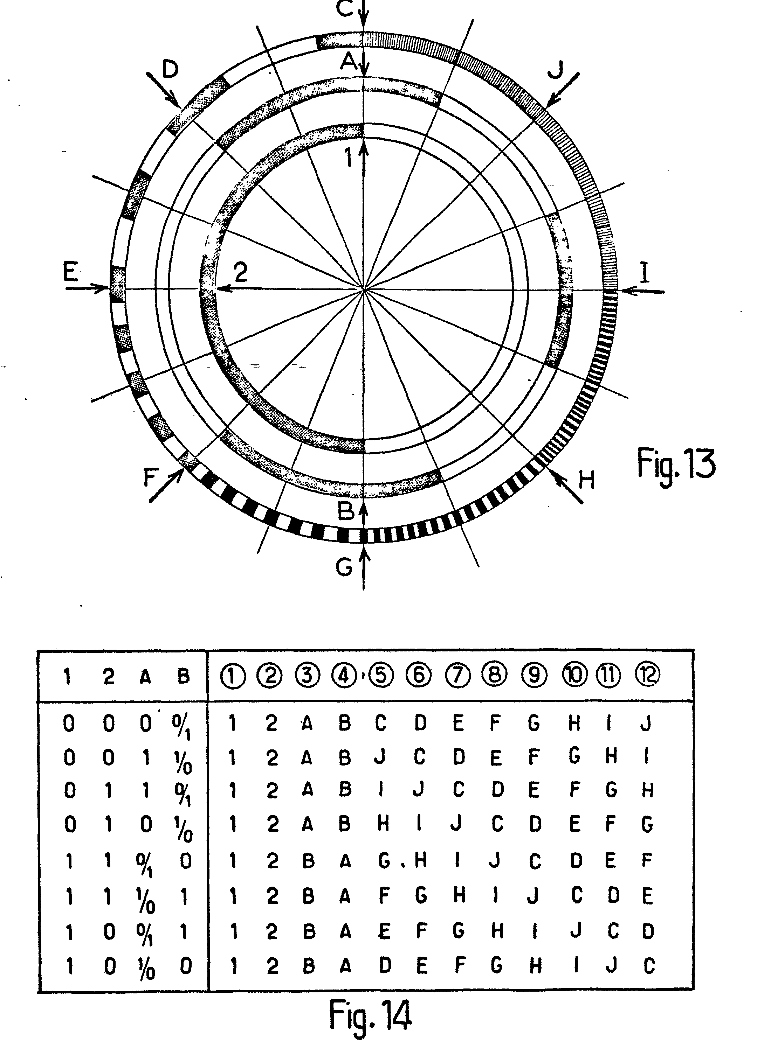

La figure 12 est un tableau représentant le codage de la position angulaire θ en fonction de la configuration des détecteurs sur un demi-tour du disque.

La figure 13 représente le disque d'un capteur de résolution $\frac{2\pi}{2^{12}}$ à codage à poids variable, et en code binaire réfléchi.

La figure 14 est la matrice de transcodage du capteur représenté figure 13.

Comme précédemment mentionné, un codeur absolu classique de résolution $\frac{2\pi}{2^{n}}$ nécessite l'utilisation d'un disque muni de $\underline{n}$ pistes lues respectivement par $\underline{n}$ détecteurs (balais, couples optoélectroniques, etc.).

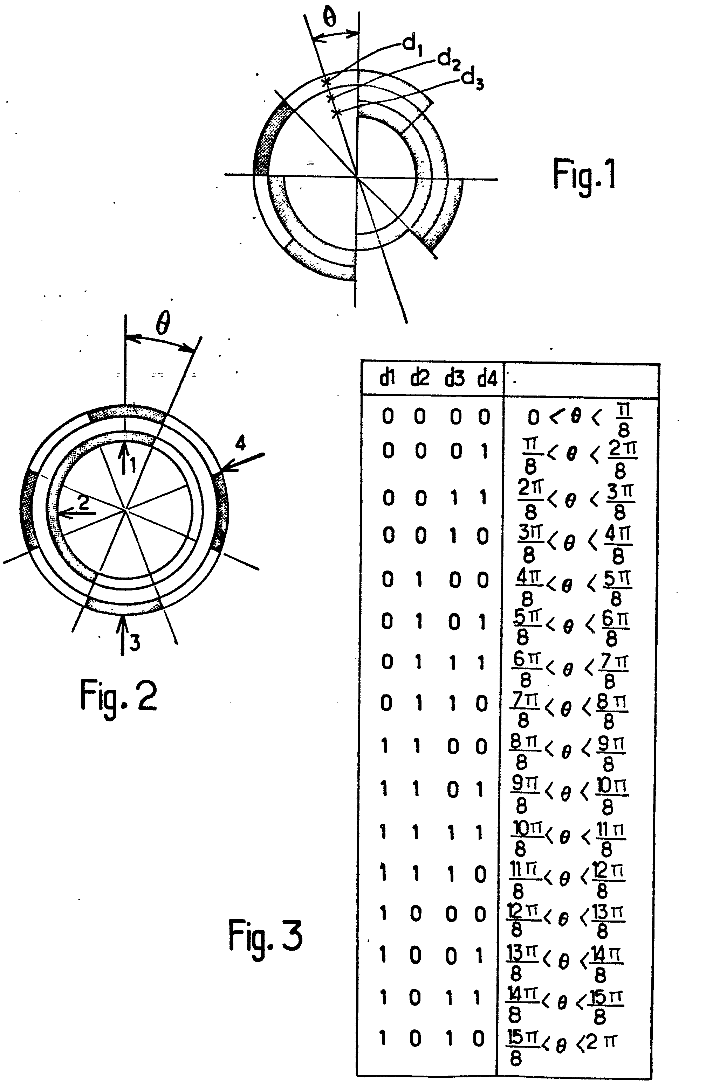

A titre d'exemple, on a représenté sur la figure 1 le disque d'un capteur rotatif à codage absolu de résolution $\frac{2\pi}{8}$ (c'est-à-dire $\frac{2\pi}{2^{3}}$). Ce disque comprend, en conséquence, trois pistes de lecture concentriques auxquelles sont respectivement associés trois détecteurs.

Il est clair que dans le cas d'un capteur de faibles dimensions et de très haute résolution, le diamètre de

la $n^{\text{ième}}$ piste serait si faible que la réalisation du disque, ainsi que le positionnement des détecteurs, nécessiteraient des précisions incompatibles avec les moyens classiques de fabrication.

La première solution proposée pour éviter cet inconvénient permet de diviser par deux le nombre de pistes nécessaires.

On rappelle que selon cette solution, chaque piste est divisée en $2 \times 4^{k'}$ secteurs et est lue par deux détecteurs disposés de manière à former entre eux un angle de $(1 + 2k) \dfrac{\pi}{2 \times 4^{k'}}$ radians (k' et k étant des nombres entiers).

Les figures 2 et 3 permettent d'illustrer le principe de ce type de capteurs.

Dans l'exemple représenté figure 2, le capteur de résolution $\dfrac{2\pi}{16}$, comprend un disque muni de deux pistes concentriques, à savoir :

- une piste munie de deux secteurs (k' = 0, k = 0) et lue par deux détecteurs 1, 2 formant un angle de $\dfrac{\pi}{2}$, et

- une piste munie de huit secteurs (k' = 1, k = 2) et lue par deux détecteurs 3, 4 formant un angle de $\dfrac{5\pi}{8}$.

Il apparaît clairement, à la lecture de la figure 3, qu'à chaque position angulaire $\theta$ du disque (à $\dfrac{\pi}{8}$ près) correspond un chiffre binaire de 4 bits directement fourni par l'état des capteurs 1, 2, 3 et 4.

Toutefois, cette solution, bien que constituant une sensible amélioration, s'avère insuffisante dans le cas de capteurs de très petites dimensions et de très haute résolution.

C'est la raison pour laquelle l'invention propose une deuxième solution basée sur le principe du codage à poids variable.

Pour mieux faire apparaître ce principe, on a tout d'abord représenté sur la figure 4 le disque d'un capteur

de résolution $\frac{\pi}{32}$.

Ce disque comprend deux pistes concentriques, à savoir :

a) Une piste intérieure comprenant deux secteurs et à laquelle sont associés deux détecteurs 1 et 2 disposés à $\frac{\pi}{2}$. Il est clair que cette disposition correspond à celle d'un codeur absolu de résolution $\frac{\pi}{2}$, à deux détecteurs, du type de ceux proposés dans la solution précédente.

b) Une piste extérieure, coaxiale à la piste intérieure et divisée en quatre zones I, II, III, IV de $\frac{\pi}{2}$ chacune. La zone I comprend deux secteurs, la zone II en comprend 4, la zone III en comprend 8 et la zone IV, 16. Au droit de cette piste sont disposés quatre détecteurs A, B, C, D disposés à $\frac{\pi}{2}$ l'un de l'autre.

Dans ce cas, la position angulaire θ du disque sera déterminée par un chiffre binaire de 6 bits, ①, ②, ③, ④, ⑤, ⑥ obtenu à partir du chiffre de 6 bits représentatifs de l'état des détecteurs 1, 2, A, B, C, D.

La transformation du chiffre binaire représentatif de l'état des capteurs en le chiffre binaire représentatif de la position angulaire θ en binaire absolu, s'obtient alors au moyen de la matrice de transcodage représentée figure 5.

Dans cette matrice, la configuration des détecteurs 1 et 2 (deux premières colonnes) permet de déterminer d'une part, les bits de poids fort ① et ②, ainsi que le poids des détecteurs A, B, C et D.

Ainsi, par exemple, si les détecteurs 1 et 2 sont tous les deux à l'état 0, les bits ① et ② seront à 0, le détecteur A déterminera le bit de poids ③, le détecteur B déterminera le bit ④, le détecteur C déterminera le bit ⑤ et le détecteur D déterminera le bit ⑥.

Par ailleurs les deux premiers bits de poids fort seront déterminés de la façon suivante : le bit ①

sera égal au bit fourni par le détecteur 1 et le bit ② sera égal au résultat de l'opération logique 1 ⊕ 2, le signe ⊕ étant représentatif du "OU exclusif".

Le tableau représenté sur la figure 6 représente les chiffres binaires ①②③④⑤⑥ correspondant aux positions angulaires θ comprises entre $\frac{2\pi}{64}$ et $\frac{16\pi}{64}$ dans le quadrant défini par l'état O des détecteurs 1 et 2.

Il est clair que les tableaux correspondant aux trois autres configurations des détecteurs 1 et 2 se déduisent d'une façon évidente.

Le disque de capteur de résolution $\frac{2\pi}{2^{12}}$ représenté figure 7 comprend trois pistes concentriques (au lieu de 12, dans le cas d'un codeur absolu de type classique), à savoir :

a) deux pistes intérieures conformées d'une façon analogue au disque du capteur de résolution $\frac{\pi}{8}$, la piste centrale étant lue par deux détecteurs 1, 2 à 90° et la deuxième piste étant lue par deux détecteurs 3 et 4 à $\frac{3\pi}{4}$,

b) une piste extérieure divisée en 8 zones comprenant, la première, 4 secteurs, la deuxième, 8 secteurs et ainsi de suite jusqu'à la huitième. Au droit de cette piste sont disposés huit détecteurs, A à H, à 45° les uns des autres.

Dans ce cas, le poids des détecteurs A, B, C, D, E, F, G, H est déterminé comme représenté figure 8 par la configuration des détecteurs 1, 2 et 3.

De la table représentée figure 8 se déduit aisément la matrice de transcodage de la figure 9 dans laquelle le bit de poids fort ① consiste en le bit fourni par le détecteur 1, le bit ② est égal au résultat de l'opération logique 1 ⊕ 2, le bit ③ consiste en le bit du détecteur 3 et le bit ④ est égal au résultat de l'opération logique 3 ⊕ 4, l'opérateur ⊕ étant le OU exclusif.

Dans le cas où le disque présente un diamètre D = 24 mm et des pistes de largeur e = 0,6 mm, les incréments prévus sur la piste de plus faible diamètre pourront présenter une largeur 1 = 0,015 mm.

La figure 10 représente le disque d'un capteur de résolution $\frac{\pi}{8}$ permettant d'illustrer le principe d'un codage à poids variable utilisant le code binaire réfléchi (code Gray).

Ce disque fait intervenir deux pistes de lecture, à savoir :

- une piste intérieure comprenant deux secteurs, cette piste étant lue par deux détecteurs 1 et 2 disposés à 90° (codeur absolu de résolution $\frac{\pi}{2}$), et

- une piste munie de six secteurs de dimensions différentes, cette piste étant lue par deux détecteurs A et B disposés à 180°.

Dans ce cas, la disposition des secteurs et celle des détecteurs sont prévues de telle manière qu'un seul détecteur change d'état à la fois.

Dans cet exemple, le poids des bits délivrés par les détecteurs A et B sont déterminés par l'état du détecteur 1, ce qui aboutit à la matrice de transcodage représentée figure 11.

De cette matrice de transcodage se déduit de façon évidente le tableau de correspondance entre les chiffres binaires fournis par les capteurs 1, 2, A, B et les chiffres binaires ①, ②, ③, ④ (en binaire réfléchi) représentatifs des positions angulaires Θ du disque, et ce, pour un demi tour du disque.

La figure 13 représente le disque d'un capteur de résolution $\frac{2\pi}{2^{12}}$ à codage à poids variable et en binaire réfléchi.

Ce disque comprend trois pistes concentriques, à savoir, deux pistes associées à quatre détecteurs, 1, 2, A, B selon la disposition du capteur de résolution $\frac{\pi}{8}$ représenté figure 10, et une piste extérieure à huit secteurs associés à huit détecteurs C, D, E, F, G, H, I, J, disposés à 45°.

Dans ce cas, les détecteurs 1 et 2 déterminent les 2 bits ① et ② de poids fort de θ ainsi que le poids relatif des bits issus des détecteurs A, B (d'une façon analogue à l'exemple représenté figure 10).

Par ailleurs, le décodage des trois bits de poids fort ①, ②, ③ de θ permet de définir le poids relatif des bits issus des détecteurs C, D, E, F, G, H, I et J.

On parvient ainsi à la réalisation de la matrice de transcodage représenté figure 14 dans laquelle pour chacun des états des détecteurs 1, 2, A, B est indiqué le poids des capteurs 1, 2, A, B, C, D, E, F, G, H, I, J dans le chiffre binaire de 12 bits ①, ②, ③, ④, ⑤, ⑥, ⑦, ⑧, ⑨, ⑩, ⑪, ⑫ représentatif de la position angulaire θ du disque.

A partir de cette matrice de transcodage, il est aisé d'obtenir un tableau de correspondance du type de celui représenté figure 6 ou figure 12, mais codé en binaire réfléchi. En raison de son importance, nous n'avons pas représenté ce tableau.

Il convient de noter que dans le cas d'un décodage à poids variable en binaire réfléchi, il convient d'effectuer, après l'application de la matrice de transcodage, une conversion binaire réfléchi/binaire naturel.

Par ailleurs, on constate que ce système présente l'avantage consistant en ce que, du fait que le bit de plus faible poids ne change que tous les deux incréments, la longueur des secteurs est deux fois plus importante que dans le cas où on utilise un codage binaire naturel. Dans l'exemple représenté figure 13, cette longueur peut être de 0,036 mm.

REVENDICATIONS

1) Capteur rotatif de position angulaire à sorties numériques faisant intervenir un disque rotatif muni d'une ou plusieurs pistes de lecture circulaires concentriques comportant chacune deux séries alternées de secteurs de deux types différents, lesdites pistes étant lues par des détecteurs appropriés susceptibles de changer d'état lorsqu'ils passent d'un secteur de l'une des séries à un secteur de l'autre série, caractérisé en ce que, pour une résolution angulaire de $\frac{2\pi}{2^n}$ le susdit disque rotatif comprend au moins $\underline{n}$ capteurs disposés respectivement sur $\frac{n}{2}$ pistes concentriques, en ce que chacune de ces pistes est divisée en $2 \times 4^{k'}$ secteurs et est lue par deux détecteurs disposés de manière à former entre eux un angle de $(1 + 2k) \dfrac{\pi}{2 \times 4^{k'}}$ radians, $k$ et $k'$ étant des nombres entiers.

2) Capteur rotatif de position angulaire à sorties numériques faisant intervenir un disque rotatif muni de plusieurs pistes de lecture circulaires concentriques comportant chacune deux séries alternées de secteurs de deux types différents, lesdites pistes étant lues par des détecteurs appropriés susceptibles de changer d'état lorsqu'ils passent d'un secteur de l'une des séries à un secteur de l'autre série, caractérisé en ce que le susdit disque comprend :

- au moins une première piste divisée en $z_1$ zones dans lesquelles les secteurs sont de longueur variable d'une zone à l'autre, un nombre de $z_1$ détecteurs permettant de définir $z_1$ bits de décodage relatif de la position angulaire $\Theta$ du disque, étant disposés autour de cette piste, et

- au moins une piste supplémentaire permettant de réaliser un système de codage, par exemple un système de codage absolu, faisant intervenir $z_2$ détecteurs permettant de définir la position du disque par rapport

aux $z_1$ détecteurs associés à la première piste, et de déterminer les $z_2$ bits de poids fort de la position angulaire $\Theta$ du disque ainsi que le poids relatif des bits issus des $z_1$ détecteurs associés à la première piste.

3) Capteur rotatif selon la revendication 2, caractérisé en ce que, pour une résolution de $\frac{2\pi}{2^n}$, le nombre total de détecteurs utilisés, soit $z_1 + z_2$ doit être au moins égal à $\underline{n}$, et en ce que la résolution du système de codage absolu qui détermine le poids des bits délivrés par les détecteurs $z_1$ associés à la première piste doit être au moins égale à $\frac{2\pi}{z_1}$.

4) Capteur rotatif selon l'une des revendications 1 et 2 dans lequel le disque comprend, en partant du centre, une ou plusieurs pistes de codage absolu et plusieurs pistes de codage à poids variable, caractérisé en ce que :

- la ou les pistes de codage absolu définissent au moins le premier bit de poids fort de la position angulaire du disque ainsi que le poids relatif des bits générés par la première piste de codage à poids variable suivante :

- Le poids relatif des bits générés par la deuxième piste de codage à poids variable est déterminé par un décodage des bits générés par la ou les pistes de codage absolu et par la première piste de codage à poids variable.

- le poids des bits générés par la $p^{\text{ième}}$ piste de codage à poids variable est déterminée par décodage des bits générés par les $p^{-1\text{ièmes}}$ pistes de codage à poids variable et par la ou les pistes de codage absolu.

5) Capteur rotatif selon l'une des revendications précédentes, caractérisé en ce que le codage des pistes peut être effectué en binaire naturel, en binaire réfléchi, ou en tout autre code.

Fig.1

Fig. 2

Fig. 3

| d1 | d2 | d3 | d4 | |
|---|---|---|---|---|
| 0 | 0 | 0 | 0 | $0 < \theta < \frac{\pi}{8}$ |
| 0 | 0 | 0 | 1 | $\frac{\pi}{8} < \theta < \frac{2\pi}{8}$ |
| 0 | 0 | 1 | 1 | $\frac{2\pi}{8} < \theta < \frac{3\pi}{8}$ |
| 0 | 0 | 1 | 0 | $\frac{3\pi}{8} < \theta < \frac{4\pi}{8}$ |
| 0 | 1 | 0 | 0 | $\frac{4\pi}{8} < \theta < \frac{5\pi}{8}$ |
| 0 | 1 | 0 | 1 | $\frac{5\pi}{8} < \theta < \frac{6\pi}{8}$ |
| 0 | 1 | 1 | 1 | $\frac{6\pi}{8} < \theta < \frac{7\pi}{8}$ |
| 0 | 1 | 1 | 0 | $\frac{7\pi}{8} < \theta < \frac{8\pi}{8}$ |
| 1 | 1 | 0 | 0 | $\frac{8\pi}{8} < \theta < \frac{9\pi}{8}$ |
| 1 | 1 | 0 | 1 | $\frac{9\pi}{8} < \theta < \frac{10\pi}{8}$ |
| 1 | 1 | 1 | 1 | $\frac{10\pi}{8} < \theta < \frac{11\pi}{8}$ |
| 1 | 1 | 1 | 0 | $\frac{11\pi}{8} < \theta < \frac{12\pi}{8}$ |
| 1 | 0 | 0 | 0 | $\frac{12\pi}{8} < \theta < \frac{13\pi}{8}$ |
| 1 | 0 | 0 | 1 | $\frac{13\pi}{8} < \theta < \frac{14\pi}{8}$ |
| 1 | 0 | 1 | 1 | $\frac{14\pi}{8} < \theta < \frac{15\pi}{8}$ |
| 1 | 0 | 1 | 0 | $\frac{15\pi}{8} < \theta < 2\pi$ |

Fig.4

Fig.5

| 1 | 2 | | ① | ② | ③ | ④ | ⑤ | ⑥ |
|---|---|---|---|---|---|---|---|---|
| 0 | 0 | | 0 | 0 | A | B | C | D |
| 0 | 1 | | 0 | 1 | D | A | B | C |
| 1 | 1 | | 1 | 0 | C | D | A | B |
| 1 | 0 | | 1 | 1 | B | C | D | A |

| ① | ② | ③ | ④ | ⑤ | ⑥ |
|---|---|---|---|---|---|
| 0 | 0 | A | B | C | D |
| 0 | 0 | 0 | 0 | 0 | 0 |
| 0 | 0 | 0 | 0 | 0 | 1 |
| 0 | 0 | 0 | 0 | 1 | 0 |
| 0 | 0 | 0 | 0 | 1 | 1 |
| 0 | 0 | 0 | 1 | 0 | 0 |
| 0 | 0 | 0 | 1 | 0 | 1 |
| 0 | 0 | 0 | 1 | 1 | 0 |
| 0 | 0 | 0 | 1 | 1 | 1 |
| 0 | 0 | 1 | 0 | 0 | 0 |
| 0 | 0 | 1 | 0 | 0 | 1 |
| 0 | 0 | 1 | 0 | 1 | 0 |
| 0 | 0 | 1 | 0 | 1 | 1 |
| 0 | 0 | 1 | 1 | 0 | 0 |
| 0 | 0 | 1 | 1 | 0 | 1 |
| 0 | 0 | 1 | 1 | 1 | 0 |
| 0 | 0 | 1 | 1 | 1 | 1 |

Fig.6

Fig.7

| 1 | 2 | 3 | poids: | 5 | 6 | 7 | 8 | 9 | 10 | 11 | 12 |
|---|---|---|--------|---|---|---|---|---|----|----|----|
| 0 | 0 | 0 | | A | B | C | D | E | F | G | H |
| 0 | 0 | 1 | | B | C | D | E | F | G | H | A |
| 0 | 1 | 0 | | C | D | E | F | G | H | A | B |
| 0 | 1 | 1 | | D | E | F | G | H | A | B | C |
| 1 | 1 | 0 | | E | F | G | H | A | B | C | D |
| 1 | 1 | 0 | | F | G | H | A | B | C | D | E |
| 1 | 0 | 0 | | G | H | A | B | C | D | E | F |
| 1 | 0 | 1 | | H | A | B | C | D | E | F | G |

Fig.8

**Fig. 9**

| 1 | 2 | 3 | 4 | | ① | ② | ③ | ④ | ⑤ | ⑥ | ⑦ | ⑧ | ⑨ | ⑩ | ⑪ | ⑫ |
|---|---|---|---|---|---|---|---|---|---|---|---|---|---|---|---|---|
| 0 | 0 | 0 | 0 | | 0 | 0 | 0 | 0 | A | B | C | D | E | F | G | H |
| 0 | 0 | 0 | 1 | | 0 | 0 | 0 | 1 | A | B | C | D | E | F | G | H |
| 0 | 0 | 1 | 1 | | 0 | 0 | 1 | 1 | B | C | D | E | F | G | H | A |
| 0 | 0 | 1 | 0 | | 0 | 0 | 1 | 0 | B | C | D | E | F | G | H | A |
| 0 | 1 | 0 | 0 | | 0 | 1 | 0 | 0 | C | D | E | F | G | H | A | B |
| 0 | 1 | 0 | 1 | | 0 | 1 | 0 | 1 | C | D | E | F | G | H | A | B |
| 0 | 1 | 1 | 1 | | 0 | 1 | 1 | 1 | D | E | F | G | H | A | B | C |
| 0 | 1 | 1 | 0 | | 0 | 1 | 1 | 0 | D | E | F | G | H | A | B | C |
| 1 | 1 | 0 | 0 | | 1 | 1 | 0 | 0 | E | F | G | H | A | B | C | D |
| 1 | 1 | 0 | 1 | | 1 | 1 | 0 | 1 | E | F | G | H | A | B | C | D |
| 1 | 1 | 1 | 1 | | 1 | 1 | 1 | 1 | F | G | H | A | B | C | D | E |
| 1 | 1 | 1 | 0 | | 1 | 1 | 1 | 0 | F | G | H | A | B | C | D | E |
| 1 | 0 | 0 | 0 | | 1 | 0 | 0 | 0 | G | H | A | B | C | D | E | F |
| 1 | 0 | 0 | 1 | | 1 | 0 | 0 | 1 | G | H | A | B | C | D | E | F |
| 1 | 0 | 1 | 1 | | 1 | 0 | 1 | 1 | H | A | B | C | D | E | F | G |
| 1 | 0 | 1 | 0 | | 1 | 0 | 1 | 0 | H | A | B | C | D | E | F | G |

**Fig. 10**

**Fig. 11**

| 1 | ① | ② | ③ | ④ |
|---|---|---|---|---|
| 0 | 1 | 2 | A | B |
| 1 | 1 | 2 | B | A |

**Fig. 12**

| 1 | 2 | A | B | | ① | ② | ③ | ④ |
|---|---|---|---|---|---|---|---|---|
| 0 | 0 | 0 | 0 | | 0 | 0 | 0 | 0 |
| 0 | 0 | 0 | 1 | | 0 | 0 | 0 | 1 |
| 0 | 0 | 1 | 1 | | 0 | 0 | 1 | 1 |
| 0 | 0 | 1 | 0 | | 0 | 0 | 1 | 0 |
| 0 | 1 | 1 | 0 | | 0 | 1 | 1 | 0 |
| 0 | 1 | 1 | 1 | | 0 | 1 | 1 | 1 |
| 0 | 1 | 0 | 0 | | 0 | 1 | 0 | 1 |
| 0 | 1 | 0 | 0 | | 0 | 1 | 0 | 0 |
| 1 | 1 | 0 | 0 | | 1 | 1 | 0 | 0 |
| 1 | 1 | 1 | 1 | | 1 | 1 | 0 | 1 |
| 1 | 1 | 1 | 1 | | 1 | 1 | 1 | 1 |
| 1 | 0 | 0 | 1 | | 1 | 1 | 1 | 0 |
| 1 | 0 | 0 | 1 | | 1 | 0 | 1 | 1 |
| 1 | 0 | 1 | 1 | | 1 | 0 | 1 | 0 |
| 1 | 0 | 1 | 0 | | 1 | 0 | 0 | 1 |
| 1 | 0 | 0 | 0 | | 1 | 0 | 0 | 0 |

0099797

5/5

Fig. 13

| 1 | 2 | A | B | ① | ② | ③ | ④ | ⑤ | ⑥ | ⑦ | ⑧ | ⑨ | ⑩ | ⑪ | ⑫ |
|---|---|---|---|---|---|---|---|---|---|---|---|---|---|---|---|
| 0 | 0 | 0 | %/1 | 1 | 2 | A | B | C | D | E | F | G | H | I | J |
| 0 | 0 | 1 | 1/0 | 1 | 2 | A | B | J | C | D | E | F | G | H | I |
| 0 | 1 | 1 | %/1 | 1 | 2 | A | B | I | J | C | D | E | F | G | H |
| 0 | 1 | 0 | 1/0 | 1 | 2 | A | B | H | I | J | C | D | E | F | G |
| 1 | 1 | %/1 | 0 | 1 | 2 | B | A | G. | H | I | J | C | D | E | F |
| 1 | 1 | 1/0 | 1 | 1 | 2 | B | A | F | G | H | I | J | C | D | E |
| 1 | 0 | %/1 | 1 | 1 | 2 | B | A | E | F | G | H | I | J | C | D |
| 1 | 0 | 1/0 | 0 | 1 | 2 | B | A | D | E | F | G | H | I | J | C |

Fig. 14

**Office européen des brevets**

## RAPPORT DE RECHERCHE EUROPEENNE

EP  83  40  1367

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | DE-A-2 165 243  (LICENTIA) <br> * Figure 1; revendication * | 1,2 | H 03 K  13/18 <br> G 01 D  5/249 |
| A | US-A-3 257 656  (E. GÖTZ et al.) <br> * Figure 1; colonne 1, lignes 44-52 * | 1,2 | |
| A | DE-A-1 294 050  (HENSOLDT) <br> * Revendication 1 * | 1,2 | |
| A | DE-A-2 023 677  (BOGAERTS) <br> * Figures 1,2,4; revendication 1 * | 1,2 | |
| A | DE-A-1 301 916  (LEITZ) <br> * Figure 5; colonne 6, lignes 22-26 * | 1,2 | **DOMAINES TECHNIQUES RECHERCHES (Int. Cl. ³)** <br><br> G 01 D <br> H 03 K |

Le présent rapport de recherche a été établi pour toutes les revendications

| Lieu de la recherche <br> LA HAYE | Date d'achèvement de la recherche <br> 02-09-1983 | Examinateur <br> MIELKE W |
|---|---|---|

OEB Form 1503. 03.82